# EUROPEAN PATENT APPLICATION

(11) **EP 4 788 097 A1**
(43) Date of publication of application: **05.08.2026**
(21) Application number: 25880921.9
(22) Date of filing: 24.02.2025
(51) Int. Cl.: H10F 77/70

(54) **SURFACE PASSIVATION STRUCTURE OF SLICED SOLAR CELL, PREPARATION METHOD THEREFOR, SLICED SOLAR CELL AND PHOTOVOLTAIC MODULE**

(30) Priority: 19.11.2024 CN 202411651362
(71) Applicant: Teranergy Technology Co., Ltd., Ningbo, Zhejiang 315206 (CN)
(72) Inventor: ZENG, Yuheng, Ningbo, Zhejiang 315206 (CN); WU, Biao, Ningbo, Zhejiang 315206 (CN); LIU, Xiaowei, Ningbo, Zhejiang 315206 (CN); LIU, Yi, Ningbo, Zhejiang 315206 (CN); ZHAO, Xukai, Ningbo, Zhejiang 315206 (CN); LIAO, Mingdun, Ningbo, Zhejiang 315206 (CN); CHEN, Shihua, Ningbo, Zhejiang 315206 (CN); LIU, Yikun, Ningbo, Zhejiang 315206 (CN); DONG, Haoxiang, Ningbo, Zhejiang 315206 (CN); YE, Jichun, Ningbo, Zhejiang 315206 (CN)
(74) Representative: Bayramoglu et al.
(86) International application number: PCT/CN2025/078692
(87) International publication number: WO 2026/107998

(57) **Abstract**

Provided are a surface passivation structure for a cut solar cell, a preparation method thereof, a cut solar cell, and a photovoltaic module. The surface passivation structure includes a silicon substrate, where one side or two opposite sides of the silicon substrate are laser-cut surfaces; a front/back surface of the silicon substrate includes a base region located in a central portion and small textured regions located on four side edges; the base region is provided with a boron emitter; a front passivation and anti-reflection layer covers the boron emitter and the small textured regions; surfaces of the boron emitter and the small textured regions are provided with pyramidal textured structures; and a pyramid in the base region has a larger dimension than pyramids in the small textured regions. This application removes pn junctions on a laser-cut edge and a non-laser-cut edge of the cut cell and forms small pyramidal textured structures. This reduces the negative impact of edge carrier recombination on efficiency, lowers the efficiency variation across different positions of the cut cell, and improves the overall efficiency of the cut cell and power of a corresponding module.

## Description

### TECHNICAL FIELD

The present disclosure relates to the technical field of crystalline silicon solar cell preparation, and in particular, to a surface passivation structure for a cut solar cell, a preparation method thereof, a cut solar cell, and a photovoltaic module.

### BACKGROUND TECHNOLOGY

In recent years, breakthroughs in solar cell cutting technology have brought a new revolution to the photovoltaic industry. The cutting technology cuts standard-sized cells into two or more identical cells in a direction perpendicular to the main busbars of the cells, followed by soldering and series connection, which can reduce series resistance loss and improve module output power.

However, for the cut cells, the cell edge surfaces cut by laser exhibit very significant carrier recombination. As the perimeter-to-area ratio of small cells increases, edge recombination becomes increasingly severe. For cut tunnel oxide passivated contact (TOPCon) cells, the efficiency loss caused by edge recombination is particularly significant. To mitigate the efficiency loss of cut TOPCon cells resulting from cutting, edge passivation technology is currently widely adopted in the industry, which involves depositing a layer of aluminum oxide (AlOₓ) with a certain thickness (approximately 50 nm) on the laser-cut edges for edge passivation. However, edge passivation equipment is incompatible with existing TOPCon production lines, occupies a large footprint, incurs high investment costs, and requires long process time and high special gas consumption, leading to high production costs and low cost-effectiveness for industrial applications. In addition, AlOₓ has strong water absorption, and prolonged storage of half-cut cells after AlOₓ deposition will result in passivation failure. Meanwhile, during deposition of the edge AlOₓ passivation film, the cells need to be tightly clamped, and AlOₓ deposition will cause cell adhesion and a significant increase in the cell breakage rate, typically reaching 0.3-0.5%. Furthermore, the upper limit of module power gain by such edge passivation technology is only 1%.

In view of the shortcomings of edge passivation technology, the Chinese Patent (CN116230810A) provides a TOPCon solar cell cutting technology. The technology removes pn junctions on the cutting center line and edges, thereby reducing carrier recombination on the edges of the cut cells and improving the photoelectric conversion efficiency of the cut cells. However, this patented technology has the following drawbacks. The use of a single laser etching, screen printing, photolithography or chemical etching method to remove the pn junction cannot guarantee the effectiveness of pn junction removal or control the morphology of the etched region. The laser cutting process on the etched region requires high power, and a large number of dislocation defects exist on the edges after cutting, which adversely affects cell efficiency. Moreover, the cut edges and non-cut edges of the cut cell have different degrees of damage and thus show different degrees of carrier recombination. As a result, the cut cells prepared by the patented technology exhibit a large efficiency variation between the edge and central positions, with a maximum difference exceeding 0.3%, which adversely affects the overall efficiency of the photovoltaic module.

### CONTENT OF THE INVENTION

In view of the shortcomings of the prior art, an objective of the present disclosure is to provide a cut cell technology suitable for industrial application. The present disclosure suppresses defect recombination on a laser-cut edge and a non-laser-cut edge, thereby improving the efficiency of an intact cell. Meanwhile, the present disclosure improves the efficiency of a cut cell and reduces the efficiency variation across different positions of the cut cell, thereby improving the power of the corresponding module.

In order to achieve the above objective, a first aspect of the present disclosure provides a surface passivation structure for a cut solar cell, including: a silicon substrate, where one side of the silicon substrate is a laser-cut surface or two opposite sides of the silicon substrate are laser-cut surfaces; a front/back surface of the silicon substrate includes a base region located in a central portion and a first small textured region, a second small textured region, a third small textured region, and a fourth small textured region located on four side edges; the first small textured region is disposed on the one side corresponding to the laser-cut surface, or the first small textured region and the second small textured region are respectively disposed on the two opposite sides corresponding to the laser-cut surfaces; the base region is provided with a boron emitter; a front passivation and anti-reflection layer covers the boron emitter, the first small textured region, the second small textured region, the third small textured region, and the fourth small textured region; surfaces of the boron emitter, the first small textured region, the second small textured region, the third small textured region, and the fourth small textured region are each provided with a pyramidal textured structure; and a pyramid in the base region has a larger dimension than pyramids in the first small textured region, the second small textured region, the third small textured region, and the fourth small textured region.

The present disclosure removes the pn junctions on the laser-cut edge and the non-laser-cut edge of the cut cell and forms small pyramidal textured structures. This reduces the negative impact of edge carrier recombination on efficiency, lowers the efficiency variation across different positions of the cut cell, and improves the overall efficiency of the cut cell.

In a preferable or optional implementation, the pyramid in the first small textured region has a height ranging between 0.2 µm and 2 µm and a width ranging between 0.5 µm and 5 µm; and/or the pyramid in the second small textured region has a height ranging between 0.2 µm and 2 µm and a width ranging between 0.5 µm and 5 µm; and/or the pyramid in the third small textured region has a height ranging between 0.2 µm and 2 µm and a width ranging between 0.5 µm and 5 µm; and/or the pyramid in the third small textured region has a height ranging between 0.2 µm and 2 µm and a width ranging between 0.5 µm and 5 µm.

The present disclosure defines the pyramid sizes of each small textured region on the edge. Such a small pyramid structure can induce dislocations on the laser-cut surface and reduce dislocation defects. Compared with a planar or large textured structure, such a small textured structure reduces the power required for laser-cutting, thereby lowering cutting damage and reducing recombination. In addition, the small textured structure can reduce optical loss and achieve excellent surface passivation.

In a preferable or optional implementation, a width W1 of the first small textured region ranges between 10 µm and 1,000 µm; a width W2 of the second small textured region ranges between 4 µm and 1,000 µm; a width W3 of the third small textured region ranges between 4 µm and 800 µm; and a width W4 of the fourth small textured region ranges between 4 µm and 800 µm.

In a preferable or optional implementation, W1, W2, W3, and W4 satisfy: W1≥W2≥W3=W4.

The present disclosure defines the widths of each of the small textured regions on the edges to ensure an edge isolation effect and eliminate recombination loss. By increasing the width of the first small textured region (or the first small textured region and the second small textured region) on the laser-cut edge with relatively high damage, the efficiency variation across different positions on the edges of the cut cell is eliminated.

In a preferable or optional implementation, a highest pyramid tip in each of the first small textured region, the second small textured region, the third small textured region, and the fourth small textured region is lower than a lowest pyramid tip in the base region.

In a preferable or optional implementation, a height difference between the highest pyramid tip in the first small textured region and the lowest pyramid tip in the base region ranges between 1 µm and 10 µm; a height difference between the highest pyramid tip in the second small textured region and the lowest pyramid tip in the base region ranges between 1 µm and 10 µm; a height difference between the highest pyramid tip in the third small textured region and the lowest pyramid tip in the base region ranges between 1 µm and 10 µm; and a height difference between the highest pyramid tip in the fourth small textured region and the lowest pyramid tip in the base region ranges between 1 µm and 10 µm.

There is a certain height difference between the surfaces of each small textured region on the edges and the base region. This ensures removal of the laser-damaged surface structure, making the passivation effect of the edge region consistent with that of the base region without introducing additional recombination loss, and enabling basically the same efficiency at edge positions of the cut cell as that at the central position.

A second aspect of the present disclosure provides a preparation method for the above surface passivation structure for a cut solar cell, including following steps:
S1: preparing the silicon substrate, and performing texturing on the front and/or back surface of the silicon substrate;
S2: performing boron diffusion on the front/back surface of the silicon substrate, and forming the boron emitter;
S3: performing laser ablation on the surface of the silicon substrate with the boron emitter, and forming a laser-treated region in an area of a certain width on the four side edges and at a position corresponding to a reserved cutting line;
S4: performing chemical etching and texturing on the laser-treated region, removing the emitter at a corresponding position, a front textured structure of the silicon substrate, and a laser-damaged layer, and forming a new small pyramidal textured structure;
S5: passivating the surface of the silicon substrate with the boron emitter, and preparing a passivation and anti-reflection layer; and
S6: performing laser cutting aligned with the reserved cutting line.

The preparation method of the present disclosure uses laser and chemical etching processes to form the small textured regions with pn junction isolation on the edges of the cut cell, suppressing the defects on the laser-cut edge and the non-laser-cut edge. The technology improves the efficiency of the intact cell, significantly improves the efficiency of the cut cell, and reduces the efficiency variation across different positions of the cut cell. In addition, the preparation method is compatible with conventional cut cell production lines, requiring only additional laser ablation and chemical etching equipment. Thus, it features low equipment cost, small footprint, low production and operation costs, high efficiency, and easy production line modification and industrial promotion.

In a preferable or optional implementation, in the step S4, the chemical etching and texturing includes: etching with a first etchant to remove the emitter; continuing the etching to remove the front textured structure of the silicon substrate, and continuing the etching to a designed depth to remove the laser-damaged layer, thereby forming a planar structure; and etching with a second etchant to form the small pyramidal textured structure on a surface of an etched region.

The present disclosure treats the edge region of the cut cell through a step-by-step etching process. The emitter and the damaged layer of the silicon substrate are first removed by etching to ensure the passivation effect of the edge region, and then etching is performed to form the small textured structure. This reduces the power required for laser-cutting, induces dislocations on the laser-cut edge, and eliminates the efficiency variation across different positions of the cut cell.

In a preferable or optional implementation, in the step S4, during chemical etching and texturing, a damaged structure on the four side edges is removed.

In the cut cell structure, various edge defects also exist on the non-laser-cut edges, which are inevitable damages during silicon wafer or cell preparation. Through laser treatment and chemical etching on these damaged edges, the present disclosure removes the damaged structures on the edges and reduces recombination.

In a preferable or optional implementation, in the step S3, there is at least one reserved cutting line. This technology is applicable to the preparation of half-cut cells, triple-cut cells, and other multi-cut cells.

A third aspect of the present disclosure provides a cut solar cell, including the above surface passivation structure for a cut solar cell, where the cut solar cell is one selected from one of a TOPCon cell, a back junction cell, and a back contact cell. The technology of the present disclosure is applicable to cut cells of various structures, with the small textured regions located on the pn junction side. The technology can improve the efficiency of the intact cell, significantly improve the efficiency of the cut cell, reduce the efficiency variation across different positions of the cut cell, and increase the overall power of a photovoltaic module.

A fourth aspect of the present disclosure provides a photovoltaic module, including the above cut solar cell. The edges of the cut cell of the present disclosure are provided with small textured regions with pn junction isolation, improving the efficiency of the cut cell and reducing the efficiency variation across different positions. The overall power of the photovoltaic module obtained by soldering and series-connecting a plurality of cut cells is improved, with the upper limit of power gain for a half-cut cell module reaching approximately 1.2-1.4%.

To sum up, compared with the prior art, the present disclosure has the following beneficial effects:
(1) The present disclosure provides a novel cut cell structure, which removes the pn junctions on the laser-cut edge and the non-laser-cut edge and forms a small pyramidal textured structure. It reduces the negative impact of edge carrier recombination on efficiency, thereby improving the efficiency of the intact cell and improving the photoelectric conversion efficiency of the cut cell.
(2) The present disclosure forms a small textured structure on the laser-cut edge, which can induce dislocation and reduce the power required for laser-cutting, thereby reducing cutting damage-induced recombination.
(3) The four side edges of the cut cell of the present disclosure each have a small textured structure, which reduces optical loss and achieves excellent surface passivation.
(4) The present disclosure removes the damaged layer on the non-laser-cut edge of the cut cell, eliminates additional recombination loss caused by damage, and makes the passivation effect on the edge consistent with that in the central region, thereby ensuring basically the same efficiency at the edge positions of the cut cell as that at the central position.
(5) The present disclosure can significantly improve module power, with an upper limit of module power gain reaching approximately 1.2-1.4%, which is higher than the upper limit of about 1% module power gain in existing edge passivation technology.
(6) The present disclosure provides a cut cell preparation method compatible with existing production lines, which features low additional equipment cost, small footprint, low production and operation costs, high efficiency, and easy production line modification and industrial promotion.
(7) The present disclosure is compatible with various photovoltaic modules, including half-cut cell, triple-cut cell, and other multi-cut cell technologies, and can further improve module power and reduce production costs.

### DESCRIPTION OF THE DRAWINGS

FIG. 1 is a side view of a cut solar cell according to a specific implementation of the present disclosure;
FIG. 2 is a front view of the cut solar cell according to a specific implementation of the present disclosure;
FIG. 3 is a flowchart of a preparation process for the cut solar cell according to a specific implementation of the present disclosure;
FIG. 4 is a schematic diagram of test positions of cut solar cells according to embodiments and comparative examples of the present disclosure;
FIG. 5 is an image showing surface morphology of an etched region of the cut solar cell according to Embodiment 1 of the present disclosure;
FIG. 6 is an image showing a measurement result of an etching depth of the cut solar cell according to Embodiment 1 of the present disclosure;
FIG. 7 is an image showing morphology of a laser-cut edge of the cut solar cell according to Embodiment 1 of the present disclosure;
FIG. 8 is an image showing morphology of a non-laser-cut edge of the cut solar cell according to Embodiment 1 of the present disclosure;
FIG. 9 is an image showing morphology of a laser-cut edge of the cut solar cell according to Comparative Example 1 of the present disclosure; and
FIG. 10 is an image showing morphology of a non-laser-cut edge of the cut solar cell according to Comparative Example 1 of the present disclosure.

### Reference Numerals:

1. silicon substrate; 11. first small textured region; 12. second small textured region; 13. third small textured region; 14. fourth small textured region; 15. base region; 16. laser-cut surface; 2. boron emitter; 3. front passivation and anti-reflection layer; 4. front electrode; 5. tunnel oxide layer; 6. phosphorus-doped polysilicon layer; 7. back passivation and anti-reflection layer; and 8. back electrode.

### SPECIFIC IMPLEMENTATIONS

To make the above objectives, features, and advantages of the present disclosure clearer and more comprehensible, specific embodiments of the present disclosure will be described in detail below with reference to the drawings. It should be noted that the following embodiments are only for illustrating the implementations and typical parameters of the present disclosure, and are not intended to limit the parameter scope described herein. Reasonable variations derived therefrom still fall within the protection scope of the claims of the present disclosure.

It should be noted that the endpoints and any values of the ranges disclosed herein are not limited to the precise range or value, and these ranges or values should be understood to include values close to these ranges or values. In terms of numerical ranges, one or more new numerical ranges can be derived by combining the end values of each range, combining the end values of each range and the individual point values and combining the individual point values, and these numerical ranges should be considered as specifically disclosed herein.

A specific implementation of the present disclosure provides a surface passivation structure for a cut solar cell, which is applicable to various cell structures such as TOPCon cells, back junction cells, and back contact cells. The surface passivation structure is located on a pn junction side, and can suppress defect recombination on a laser-cut edge and a non-laser-cut edge, thereby improving the efficiency of the intact cell. Meanwhile, it improves the efficiency of the cut cell, reduces efficiency variation across different positions of the cut cell, and boosts the overall power of the photovoltaic module.

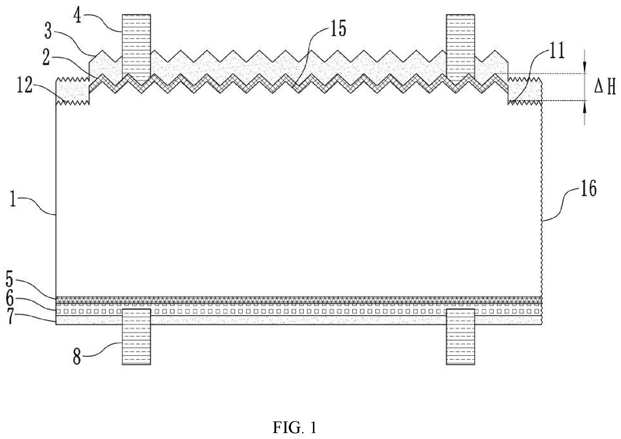

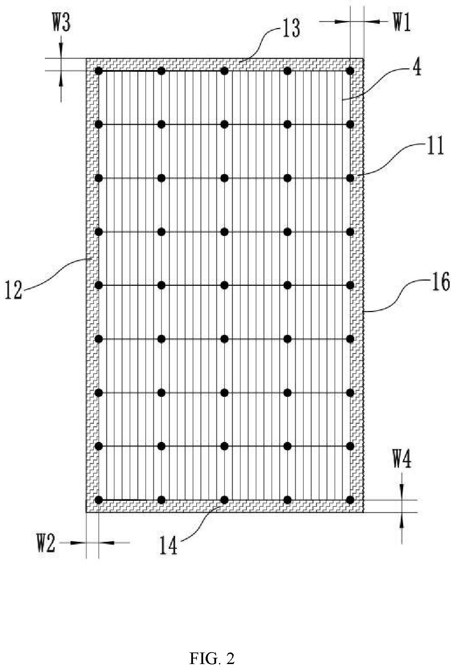

As shown in FIGS. 1 and 2, taking a half-cut TOPCon cell as an example, the cut cell includes silicon substrate 1, and one side surface of the silicon substrate 1 is laser-cut surface 16. This technology is also applicable to triple-cut cells and other multi-cut cells, where in a corresponding embodiment, two opposite side surfaces of the silicon substrate 1 are laser-cut surfaces 16.

A front surface of the silicon substrate 1 includes base region 15 in a central portion and small textured regions on four side edges, defined respectively as first small textured region 11, second small textured region 12, third small textured region 13, and fourth small textured region 14. The first small textured region 11 is disposed on the one side corresponding to the laser-cut surface 16. A surface of the base region 15 is provided with a pyramidal textured structure, and surfaces of the first small textured region 11, the second small textured region 12, the third small textured region 13, and the fourth small textured region 14 are provided with small pyramidal textured structures. A pyramid size in each of the small textured regions on the edges is smaller than a pyramid size in the base region 15.

In a specific embodiment, the pyramid in each small textured region has a height ranging between 0.2 µm and 2 µm and a width ranging between 0.5 µm and 5 µm. Such a pyramidal textured structure can reduce efficiency variation across different positions of the cut cell and improve its overall efficiency. In addition, the small textured structure can induce dislocations on the laser-cut surface 16, lower the power required for laser-cutting, and reduce dislocation defects and cutting damage.

As shown in FIG. 1, the base region 15 on the front surface of the silicon substrate 1 is provided with boron emitter 2, whereas no boron emitter 2 is formed in the small textured regions on the edges, thereby forming a pn junction isolation structure on the four side edges to eliminate edge recombination. Front passivation and anti-reflection layer 3 covers the boron emitter 2 and the small textured regions on the four side edges, such that the small textured structure can reduce optical loss and achieve excellent surface passivation. A typical structure of the front passivation and anti-reflection layer 3 is a stack of aluminum oxide and silicon nitride films. Front electrode 4 extends through the front passivation and anti-reflection layer 3 and contacts the boron emitter 2.

Furthermore, a highest pyramid tip in each small textured region is lower than a lowest pyramid tip in the base region 15, with a height difference ΔH within 1-10 µm. This ensures removal of the laser-damaged surface structure of the silicon substrate 1, renders the passivation effect of the edge regions consistent with that of the base region 15, and avoids additional recombination loss.

A back surface of the silicon substrate 1 is sequentially covered with tunnel oxide layer 5, phosphorus-doped polysilicon layer 6, and back passivation and anti-reflection layer 7. A typical material of the tunnel oxide layer 5 is silicon oxide, with a typical thickness of 0.5-3 nm. A typical structure of the back passivation and anti-reflection layer 7 is a stack of silicon nitride films. Back electrode 8 extends through the back passivation and anti-reflection layer 7 and contacts the phosphorus-doped polysilicon layer 6.

As shown in FIG. 2, the first small textured region 11 has a width of W1, the second small textured region 12 has a width of W2, the third small textured region 13 has a width of W3, and the fourth small textured region 14 has a width of W4. In a preferable embodiment, the widths of the small textured regions on the edges are defined as follows: W1: within 10-1,000 µm, W2: within 4-800 µm, W3: within 4-800 µm, and W4: within 4-800 µm, thereby ensuring edge isolation and eliminating recombination loss. In addition, W2, W3, and W4 are generally equal to ensure consistent efficiency at positions along non-laser-cut edges. The width of the first small textured region 11 may be equal to that of the other small textured regions, or W1 may be slightly increased according to the degree of laser-cutting damage, i.e., W1≥W2=W3=W4, thereby eliminating efficiency variation between the laser-cut edge and the non-laser-cut edge of the cut cell.

In embodiments of triple-cut and multi-cut cells, two opposite side surfaces of the silicon substrate 1 define laser-cut surfaces 16, and the first small textured region 11 and the second small textured region 12 are disposed respectively on sides corresponding to the two laser-cut surfaces 16. In this case, W1, W2, W3, and W4 satisfy: W1=W2≥W3=W4.

The cut cell with the above structure exhibits low leakage, low saturation current density, high fill factor, and high cell efficiency, with very small efficiency variation across different positions. The overall power of a photovoltaic module obtained by soldering and series-connecting a plurality of cut cells is significantly improved.

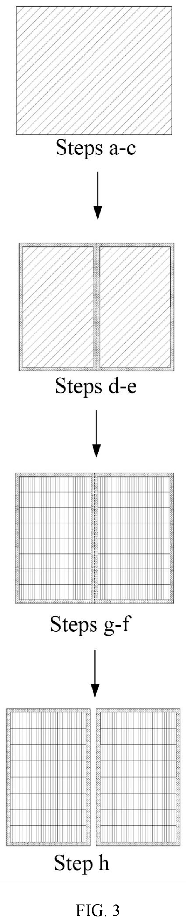

As shown in FIG. 3, a preparation method for the above cut solar cell includes the following steps.

Step a: The silicon substrate is prepared, double-sided texturing is performed on the silicon substrate, and standard Radio Corporation of America cleaning (RCA) is performed.

Step b: Boron diffusion is performed on the front surface of the silicon substrate to form the boron emitter.

Step c: The back surface of the silicon substrate is polished, and the tunnel oxide layer and the phosphorus-doped polysilicon layer are prepared on the back surface.

Step d: Laser ablation is performed in an area of a certain width on the four side edges of the front surface of the silicon substrate and at a position corresponding to a reserved cutting line (dashed line in FIG. 3) to form a laser-treated region.

Step e: Chemical etching and texturing are performed on the laser-treated region, and the emitter at a corresponding position, the textured structure on the front surface of the silicon substrate, and a laser-damaged layer are removed to form a new small pyramidal textured structure.

In a specific embodiment, a step-by-step etching process is employed for surface treatment. Specifically, first, etching with a first etchant is performed to remove the emitter. The etching is continued to remove the textured structure on the front surface of the silicon substrate, thereby forming a planar structure. The etching is continued to reach a designed depth and remove the laser-damaged layer. Then, etching with a second etchant is performed to form the small pyramidal textured structure on a surface of an etched region. In a specific embodiment, typical components of the first etchant include sodium hydroxide, hydrogen peroxide, alkaline polishing additive, and deionized water. Typical components of the second etchant include sodium hydroxide, texturing additive, and deionized water. By adjusting etching time and selecting different etchants, the etching effect can be controlled, thereby yielding the designed small pyramidal textured structure.

Step f: Double-sided passivation is performed on the silicon substrate, and the front passivation and anti-reflection layer and the back passivation and anti-reflection layer are prepared.

Step g: Double-sided metallization is performed, the front electrode is prepared on the front surface of the silicon substrate, and the back electrode is prepared on the back surface.

Step h: Laser cutting aligned with the reserved cutting line is performed to obtain the cut solar cell.

The above process is compatible with conventional cut cell production lines, requiring only additional laser ablation and chemical etching equipment. It features low equipment cost, small footprint, low production and operation costs, and high efficiency. It significantly reduces efficiency variation across the positions of the cut cell and improves the efficiency of the photovoltaic module, showing excellent industrial application prospects.

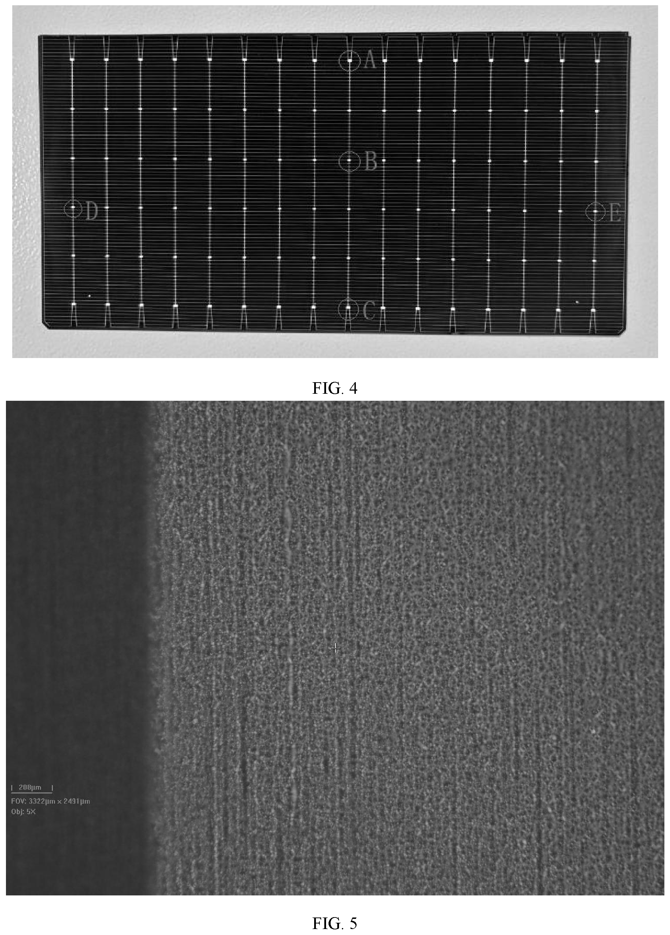

The technical solutions and effects of the present disclosure are illustrated by specific embodiments below. The performance of the cut solar cells in the embodiments and Comparative Examples is tested by Suns-Voc. The test positions are shown in FIG. 4, where position A corresponds to the laser-cut edge.

### Embodiment 1

A cut solar cell is prepared according to the following steps.

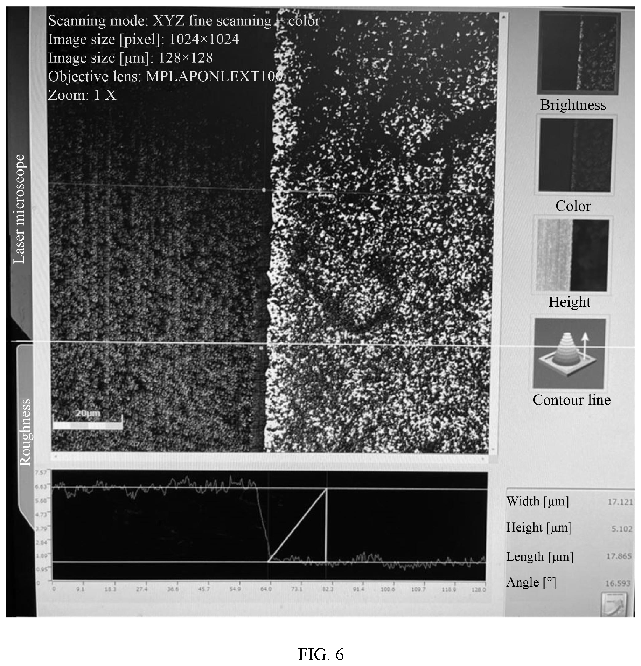

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width on four side edges of the front surface of the silicon substrate and at a position corresponding to a reserved cutting line, thereby forming laser-treated regions. The laser-treated regions on the four side edges have a width of 40 µm, and the laser-treated region corresponding to the reserved cutting line has a width of 80 µm, with the reserved cutting line located on a center line of the area. Chemical etching is then performed on the laser-treated regions. Etching with a first etchant is performed to remove the emitter and the front-side textured structure of the silicon substrate, thereby forming a planar structure. The etching is continued to a depth of 5.6 µm. Etching with a second etchant is then performed to form a small pyramidal textured structure (as shown in FIG. 5) on a surface of the etched region, where a pyramid has a height ranging between 0.2 µm and 2 µm and a width ranging between 0.5 µm and 5 µm. A stylus profiler is used to measure a height difference between a pyramid tip on the surface of the etched region and a pyramid tip on a surface of a non-etched region, and the result is shown in FIG. 6. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 114 W to obtain the cut solar cell.

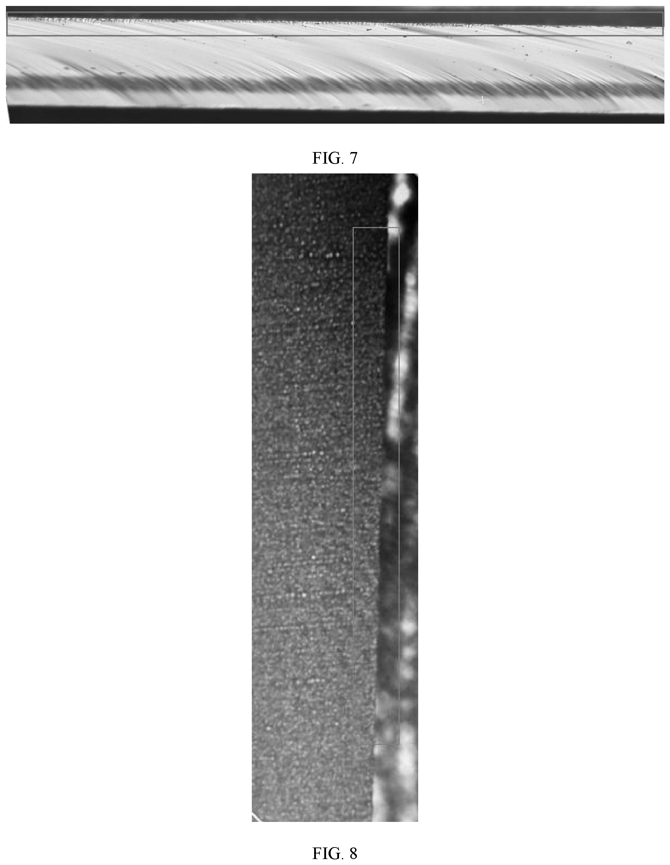

The morphology of the laser-cut edge of the cut solar cell is shown in FIG. 7 (the red box indicates the laser-cut edge). Almost no jagged edge defects are observed, ensuring low edge recombination. The morphology of the non-laser-cut edge is shown in FIG. 8 (the red box indicates the edge). The edge is relatively smooth and essentially damage-free, also ensuring low edge recombination.

The performance across different positions (test positions shown in FIG. 4) and the overall performance of the cut cell prepared in this embodiment were tested. The results are shown in Table 1 below. The maximum difference in pseudo-efficiency (*pEff*) among the positions is 0.12%, the standard deviation is 4.39×10⁻⁴, and the overall pseudo-efficiency (*pEff*) is 26.07%.

**Table 1 Performance test results of the cut cell in Embodiment 1 (Suns-Voc method)**

| Embodiment 1 | *pV_{oc}*(mV) | *pJ_{sc}*(mA/cm²) | *pFF*(%) | *pEff*(%) |
|---|---|---|---|---|
| Position A | 735 | 41.68 | 85.22 | 26.02 |
| Position B | 739 | 41.82 | 85.25 | 26.14 |
| Position C | 736 | 41.72 | 85.40 | 26.07 |
| Position D | 737 | 41.72 | 85.53 | 26.06 |
| Position E | 737 | 41.55 | 85.54 | 26.09 |
| Overall | 737 | 41.75 | 85.41 | 26.07 |

### Embodiment 2

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width on four side edges of the front surface of the silicon substrate and at a position corresponding to a reserved cutting line, thereby forming laser-treated regions. The laser-treated regions on the four side edges have a width of 40 µm, and the laser-treated region corresponding to the reserved cutting line has a width of 100 µm, with the reserved cutting line located on a center line of the area. Chemical etching is then performed on the laser-treated regions. Etching with a first etchant is performed to remove the emitter and the front-side textured structure of the silicon substrate, thereby forming a planar structure. The etching is continued to a depth of 4 µm. Etching with a second etchant is then performed to form a small pyramidal textured structure on a surface of the etched region, where a pyramid has a height ranging between 0.2 µm and 2 µm and a width ranging between 0.5 µm and 5 µm. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 114 W to obtain the cut solar cell.

The performance across different positions and the overall performance of the cut cell prepared in this embodiment were tested. The results are shown in Table 2 below. The maximum difference in pseudo-efficiency (*pEff*) among the positions is 0.08%, the standard deviation is 3.0×10⁻⁴, and the overall pseudo-efficiency (*pEff*) is 26.12%.

**Table 2 Performance test results of the cut cell in Embodiment 2 (Suns-Voc method)**

| Embodiment 2 | *pV_{oc}*(mV) | *pJ_{sc}*(mA/cm²) | *pFF*(%) | *pEff*(%) |
|---|---|---|---|---|
| Position A | 736 | 41.63 | 85.32 | 26.07 |
| Position B | 740 | 41.81 | 85.35 | 26.15 |
| Position C | 736 | 41.71 | 85.41 | 26.10 |
| Position D | 738 | 41.69 | 85.53 | 26.09 |
| Position E | 737 | 41.60 | 85.54 | 26.11 |
| Overall | 738 | 41.77 | 85.42 | 26.12 |

### Embodiment 3

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width on four side edges of the front surface of the silicon substrate and at a position corresponding to a reserved cutting line, thereby forming laser-treated regions. The laser-treated regions on the four side edges have a width of 40 µm, and the laser-treated region corresponding to the reserved cutting line has a width of 80 µm, with the reserved cutting line located on a center line of the area. Chemical etching is then performed on the laser-treated regions. Etching with a first etchant is performed to remove the emitter and the front-side textured structure of the silicon substrate, thereby forming a planar structure. The etching is continued to a depth of 4 µm. Etching with a second etchant is then performed to form a small pyramidal textured structure on a surface of the etched region, where a pyramid has a height ranging between 0.2 µm and 2 µm and a width ranging between 0.5 µm and 5 µm. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 130 W to obtain the cut solar cell.

The performance across different positions and the overall performance of the cut cell prepared in this embodiment were tested. The results are shown in Table 3 below. The maximum difference in pseudo-efficiency (*pEff*) among the positions is 0.13%, the standard deviation is 4.7×10⁻⁴, and the overall pseudo-efficiency (*pEff*) is 26.04%.

**Table 3 Performance test results of the cut cell in Embodiment 3 (Suns-Voc method)**

| Embodiment 3 | *pV_{oc}*(mV) | *pJ_{sc}*(mA/cm²) | *pFF*(%) | *pEff*(%) |
|---|---|---|---|---|
| Position A | 735 | 41.71 | 85.32 | 25.99 |
| Position B | 738 | 41.80 | 85.30 | 26.12 |
| Position C | 737 | 41.71 | 85.40 | 26.06 |
| Position D | 737 | 41.61 | 85.34 | 26.07 |
| Position E | 737 | 41.63 | 85.35 | 26.08 |
| Overall | 737 | 41.75 | 85.40 | 26.04 |

### Embodiment 4

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width on four side edges of the front surface of the silicon substrate and at a position corresponding to a reserved cutting line, thereby forming laser-treated regions. The laser-treated regions on the four side edges have a width of 40 µm, and the laser-treated region corresponding to the reserved cutting line has a width of 80 µm, with the reserved cutting line located on a center line of the area. Chemical etching is then performed on the laser-treated regions. Etching with a first etchant is performed to remove the emitter and the front-side textured structure of the silicon substrate, thereby forming a planar structure. The etching is continued to a depth of 10 µm. Etching with a second etchant is then performed to form a small pyramidal textured structure on a surface of the etched region, where a pyramid has a height ranging between 0.2 µm and 2 µm and a width ranging between 0.5 µm and 5 µm. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 114 W to obtain the cut solar cell.

The performance across different positions and the overall performance of the cut cell prepared in this embodiment were tested. The results are shown in Table 4 below. The maximum difference in pseudo-efficiency (*pEff*) among the positions is 0.10%, the standard deviation is 3.8×10⁻⁴, and the overall pseudo-efficiency (*pEff*) is 26.11%.

**Table 4 Performance test results of the cut cell in Embodiment 4 (Suns-Voc method)**

| Embodiment 4 | *pV_{oc}*(mV) | *pJ_{sc}*(mA/cm²) | *pFF*(%) | *pEff*(%) |
|---|---|---|---|---|
| Position A | 736 | 41.78 | 85.41 | 26.06 |
| Position B | 739 | 41.83 | 85.45 | 26.16 |
| Position C | 737 | 41.77 | 85.35 | 26.09 |
| Position D | 737 | 41.72 | 85.34 | 26.10 |
| Position E | 737 | 41.77 | 85.35 | 26.08 |
| Overall | 738 | 41.78 | 85.41 | 26.11 |

### Embodiment 5

2,000 cut cells are prepared using the method of Embodiment 1, and their efficiency is tested using an IV curve tracer. The average efficiency of the cut cells is measured to be 26.21%, and average values of key cell parameters are: *V_{oc}*=742.5 mV, *FF*=84.94%, and *I_{sc}*=13.7658 A. The cell efficiency is higher than that of Comparative Example 5.

### Embodiment 6

Cut cells are prepared using the method of Embodiment 1, and assembled into 10 modules. The modules each include 108 half-cut TOPCon cells, each with a size of 9.1 cm × 18.2 cm. Testing shows that the average power of the modules is 446.6 W, which is significantly higher than that of Comparative Example 6.

### Comparative Example 1

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 130 W. Aluminum oxide with a thickness of 30 nm is deposited on a laser-cut surface by ALD to obtain a cut solar cell.

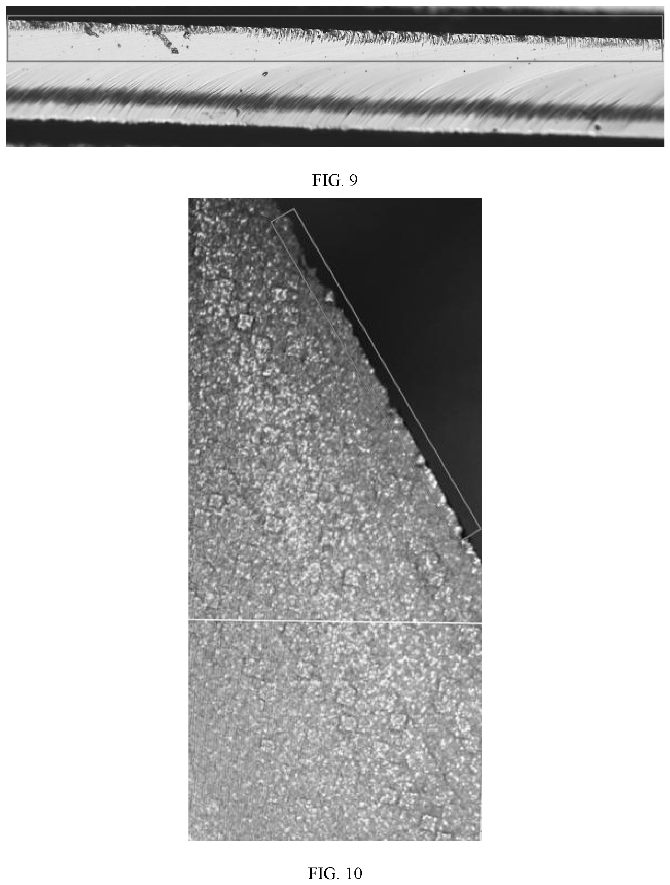

The morphology of the laser-cut edge of the cut solar cell is shown in FIG. 9 (the red box indicates the laser-cut edge). The edge formed by cutting a large texture exhibits significant jagged defects and severe recombination. Laser-cutting of a planar surface results in even more severe edge defects. The morphology of the non-laser-cut edge is shown in FIG. 10 (the red box indicates the edge). Even without laser cutting, various edge damage defects exist in this region, which increase edge recombination.

The performance across different positions and the overall performance of the cut cell prepared in this comparative example were tested. The results are shown in Table 5 below. The maximum difference in pseudo-efficiency (*pEff*) among the positions is 0.28%, the standard deviation is 10.2×10⁻⁴, and the overall pseudo-efficiency (*pEff*) is 25.82%.

**Table 5 Performance test results of the cut cell in Comparative Example 1 (Suns-Voc method)**

| Comparative Example 1 | *pV_{oc}*(mV) | *pJ_{sc}*(mA/cm²) | *pFF*(%) | *pEff*(%) |
|---|---|---|---|---|
| Position A | 735 | 41.78 | 85.32 | 25.69 |
| Position B | 738 | 41.83 | 85.31 | 25.97 |
| Position C | 736 | 41.76 | 85.41 | 25.81 |
| Position D | 737 | 41.71 | 85.34 | 25.88 |
| Position E | 737 | 41.78 | 85.35 | 25.85 |
| Overall | 735 | 41.78 | 85.36 | 25.82 |

### Comparative Example 2

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width at a position corresponding to a reserved cutting line of the silicon substrate, thereby forming a laser-treated region. The laser-treated region has a width of 80 µm, with the reserved cutting line located on a center line of the area. Chemical etching is then performed on the laser-treated region. Etching with a first etchant is performed to remove the emitter and the front-side textured structure of the silicon substrate, thereby forming a planar structure. The etching is continued to a depth of 4 µm. Etching with a second etchant is then performed to form a small pyramidal textured structure on a surface of the etched region, where a pyramid has a height ranging between 0.2 µm and 2 µm and a width ranging between 0.5 µm and 5 µm. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 130 W to obtain the cut solar cell.

The performance across different positions and the overall performance of the cut cell prepared in this comparative example were tested. The results are shown in Table 6 below. The maximum difference in pseudo-efficiency (*pEff*) among the positions is 0.19%, the standard deviation is 8.5×10⁻⁴, and the overall pseudo-efficiency (*pEff*) is 25.94%.

**Table 6 Performance test results of the cut cell in Comparative Example 2 (Suns-Voc method)**

| Comparative Example 2 | *pV_{oc}*(mV) | *pJ_{sc}*(mA/cm²) | *pFF*(%) | *pEff*(%) |
|---|---|---|---|---|
| Position A | 736 | 41.77 | 85.33 | 25.95 |
| Position B | 739 | 41.84 | 85.42 | 26.09 |
| Position C | 737 | 41.77 | 85.36 | 25.89 |
| Position D | 737 | 41.71 | 85.34 | 25.92 |
| Position E | 737 | 41.78 | 85.39 | 25.88 |
| Overall | 737 | 41.77 | 85.37 | 25.94 |

### Comparative Example 3

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width on four side edges of the front surface of the silicon substrate and at a position corresponding to a reserved cutting line, thereby forming laser-treated regions. The laser-treated regions on the four side edges have a width of 40 µm, and the laser-treated region corresponding to the reserved cutting line has a width of 80 µm, with the reserved cutting line located on a center line of the area. Chemical etching is then performed on the laser-treated regions. Etching with a first etchant is performed to remove the emitter and the front-side textured structure of the silicon substrate, thereby forming a planar structure. The etching is continued to a depth of 4 µm. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 141 W to obtain the cut solar cell.

The performance across different positions and the overall performance of the cut cell prepared in this comparative example were tested. The results are shown in Table 7 below. The maximum difference in pseudo-efficiency (*pEff*) among the positions is 0.22%, the standard deviation is 8.2×10⁻⁴, and the overall pseudo-efficiency (*pEff*) is 25.97%.

**Table 7 Performance test results of the cut cell in Comparative Example 3 (Suns-Voc method)**

| Comparative Example 3 | *pV_{oc}*(mV) | *pJ_{sc}*(mA/cm²) | *pFF*(%) | *pEff*(%) |
|---|---|---|---|---|
| Position A | 735 | 41.78 | 85.32 | 25.88 |
| Position B | 739 | 41.85 | 85.33 | 26.10 |
| Position C | 737 | 41.78 | 85.43 | 25.99 |
| Position D | 737 | 41.74 | 85.34 | 26.02 |
| Position E | 737 | 41.73 | 85.35 | 26.05 |
| Overall | 737 | 41.79 | 85.39 | 25.97 |

### Comparative Example 4

A cut solar cell is prepared according to the following steps.

An n-type silicon wafer is prepared, subjected to front-side texturing, back-side polishing, and standard RCA cleaning. Boron diffusion is performed on a front surface of the silicon wafer to form a boron emitter, and a back surface of the silicon wafer is polished to remove borosilicate glass. Nano-silicon oxide and phosphorus-doped amorphous silicon are sequentially deposited on the back surface, followed by annealing at 900°C for 30 min to obtain a TOPCon wafer. Laser ablation is performed in an area of a certain width on four side edges of the front surface of the silicon substrate and at a position corresponding to a reserved cutting line, thereby forming laser-treated regions. The laser-treated regions on the four side edges have a width of 40 µm, and the laser-treated region corresponding to the reserved cutting line has a width of 80 µm, with the reserved cutting line located on a center line of the area. Chemical etching is then performed on the laser-treated regions. Etching with a first etchant is performed to remove the emitter and the front-side textured structure of the silicon substrate, thereby forming a planar structure. The etching is continued to a depth of 0.5 µm. Etching with a second etchant is then performed to form a small pyramidal textured structure on a surface of the etched region, where a pyramid has a height ranging between 0.2 µm and 2 µm and a width ranging between 0.5 µm and 5 µm. An aluminum oxide film is prepared on the front surface of the sample, followed by double-sided deposition of silicon nitride films. Double-sided metallization is performed on the passivated wafer. Laser cutting aligned with the reserved cutting line is then performed at a laser power of 114 W to obtain the cut solar cell.

The performance across different positions and the overall performance of the cut cell prepared in this comparative example were tested. The results are shown in Table 8 below. The maximum difference in pseudo-efficiency (*pEff*) among the positions is 0.15%, the standard deviation is 5.4×10⁻⁴, and the overall pseudo-efficiency (*pEff*) is 26.01%.

**Table 8 Performance test results of the cut cell in Comparative Example 4 (Suns-Voc method)**

| Comparative Example 4 | *pV_{oc}*(mV) | *pJ_{sc}*(mA/cm²) | *pFF*(%) | *pEff*(%) |
|---|---|---|---|---|
| Position A | 736 | 41.77 | 85.35 | 25.96 |
| Position B | 739 | 41.86 | 85.40 | 26.11 |
| Position C | 738 | 41.76 | 85.43 | 26.05 |
| Position D | 737 | 41.72 | 85.34 | 26.02 |
| Position E | 737 | 41.73 | 85.37 | 26.04 |
| Overall | 737 | 41.76 | 85.34 | 26.01 |

### Comparative Example 5

2,000 cut cells are prepared using the method of Comparative Example 1, and their efficiency is tested. The average efficiency of the cut cells is measured to be 26.13%, and average values of key cell parameters are: *V_{oc}*=741.4 mV, *FF*=84.73%, and *I_{sc}*=13.7782 A.

### Comparative Example 6

Cut cells are prepared using the method of Comparative Example 1, and assembled into 10 modules. The modules each include 108 half-cut TOPCon cells, each with a size of 9.1 cm × 18.2 cm. Testing shows that the average power of the modules is 442.1 W.

Taking TOPCon cells as an example in the above embodiments, applying the surface passivation structure of the present disclosure to back junction cells and back contact cells can also achieve similar technical effects.

Although being disclosed as described above, the present disclosure is not limited to this. Those skilled in the art may make various changes and modifications without departing from the spirit and scope of the present disclosure. Therefore, the protection scope of the present disclosure shall be subject to the scope defined by the claims.

## Claims

1. A surface passivation structure for a cut solar cell, comprising: a silicon substrate, wherein one side of the silicon substrate is a laser-cut surface or two opposite sides of the silicon substrate are laser-cut surfaces; a front/back surface of the silicon substrate comprises a base region located in a central portion and a first small textured region, a second small textured region, a third small textured region, and a fourth small textured region that are located on four side edges, respectively; the first small textured region is disposed on the one side corresponding to the laser-cut surface, or the first small textured region and the second small textured region are respectively disposed on the two opposite sides corresponding to the laser-cut surfaces; the base region is provided with a boron emitter; a front passivation and anti-reflection layer covers the boron emitter, the first small textured region, the second small textured region, the third small textured region, and the fourth small textured region; surfaces of the boron emitter, the first small textured region, the second small textured region, the third small textured region, and the fourth small textured region are each provided with a pyramidal textured structure; and a pyramid in the base region has a larger dimension than pyramids in the first small textured region, the second small textured region, the third small textured region, and the fourth small textured region.

2. The surface passivation structure for the cut solar cell according to claim 1, wherein the pyramid in the first small textured region has a height ranging between 0.2 µm and 2 µm and a width ranging between 0.5 µm and 5 µm; and/or the pyramid in the second small textured region has a height ranging between 0.2 µm and 2 µm and a width ranging between 0.5 µm and 5 µm; and/or the pyramid in the third small textured region has a height ranging between 0.2 µm and 2 µm and a width ranging between 0.5 µm and 5 µm; and/or the pyramid in the third small textured region has a height ranging between 0.2 µm and 2 µm and a width ranging between 0.5 µm and 5 µm.

3. The surface passivation structure for the cut solar cell according to claim 1, wherein a width W1 of the first small textured region ranges between 10 µm and 1,000 µm; a width W2 of the second small textured region ranges between 4 µm and 1,000 µm; a width W3 of the third small textured region ranges between 4 µm and 800 µm; and a width W4 of the fourth small textured region ranges between 4 µm and 800 µm.

4. The surface passivation structure for the cut solar cell according to claim 3, wherein W1, W2, W3, and W4 satisfy a following relationship: W1≥W2≥W3=W4.

5. The surface passivation structure for the cut solar cell according to any one of claims 1 to 4, wherein a highest pyramid tip in each of the first small textured region, the second small textured region, the third small textured region, and the fourth small textured region is lower than a lowest pyramid tip in the base region.

6. The surface passivation structure for the cut solar cell according to claim 5, wherein a height difference between the highest pyramid tip in the first small textured region and the lowest pyramid tip in the base region ranges between 1 µm and 10 µm; a height difference between the highest pyramid tip in the second small textured region and the lowest pyramid tip in the base region ranges between 1 µm and 10 µm; a height difference between the highest pyramid tip in the third small textured region and the lowest pyramid tip in the base region ranges between 1 µm and 10 µm; and a height difference between the highest pyramid tip in the fourth small textured region and the lowest pyramid tip in the base region ranges between 1 µm and 10 µm.

7. A preparation method for the surface passivation structure for the cut solar cell according to any one of claims 1 to 6, comprising following steps:
S1: preparing the silicon substrate, and performing texturing on the front and/or back surface of the silicon substrate;
S2: performing boron diffusion on the front/back surface of the silicon substrate, and forming the boron emitter;
S3: performing laser ablation on the surface of the silicon substrate with the boron emitter, and forming a laser-treated region in an area of a certain width on the four side edges and at a position corresponding to a reserved cutting line;
S4: performing chemical etching and texturing on the laser-treated region, removing the emitter at a corresponding position, a front textured structure of the silicon substrate, and a laser-damaged layer, and forming a new small pyramidal textured structure;
S5: passivating the surface of the silicon substrate with the boron emitter, and preparing a passivation and anti-reflection layer; and
S6: performing laser cutting aligned with the reserved cutting line.

8. The preparation method for the surface passivation structure for the cut solar cell according to claim 7, wherein in the step S4, the chemical etching and texturing comprises: etching with a first etchant to remove the emitter; continuing the etching to remove the front textured structure of the silicon substrate, and continuing the etching to a designed depth to remove the laser-damaged layer, thereby forming a planar structure; and etching with a second etchant to form the small pyramidal textured structure on a surface of an etched region.

9. The preparation method for the surface passivation structure for the cut solar cell according to claim 7, wherein in the step S4, during chemical etching and texturing, a damaged structure on the four side edges is removed.

10. The preparation method for the surface passivation structure for the cut solar cell according to claim 7, wherein in the step S3, there is at least one reserved cutting line.

11. A cut solar cell, comprising the surface passivation structure for the cut solar cell according to any one of claims 1 to 6, wherein the cut solar cell is one selected from a tunnel oxide passivated contact (TOPCon) cell, a back junction cell, and a back contact cell.

12. A photovoltaic module, comprising the cut solar cell according to claim 11.
